Europäisches Patentamt

**European Patent Office**

**Office européen des brevets**

(11) Numéro de publication: **0 272 171 B1**

## (12) FASCICULE DE BREVET EUROPEEN

(45) Date de publication de fascicule du brevet:
**22.01.92**

(21) Numéro de dépôt: **87402515.8**

(22) Date de dépôt: **06.11.87**

(51) Int. Cl.⁵: **H04L 25/22**, H03K 17/687

(54) **Circuit d'émission de signaux numériques pour réseau téléphonique.**

(30) Priorité: **14.11.86 FR 8615864**

(43) Date de publication de la demande:
**22.06.88 Bulletin 88/25**

(45) Mention de la délivrance du brevet:
**22.01.92 Bulletin 92/04**

(84) Etats contractants désignés:
**DE FR GB IT NL SE**

(56) Documents cités:
**WO-A-85/05742**
**GB-A- 1 598 679**
**US-A- 4 164 842**

**PATENT ABSTRACTS OF JAPAN, vol, 7, no. 284 (E-217)[1429], 17 décembre 1983; & JP-A-58 162 128 (MATSUSHITA DENKO K.K.) 26-09-1983**

(73) Titulaire: **SGS-THOMSON MICROELECTRO-NICS S.A.**
**7, Avenue Galliéni**
**F-94250 Gentilly(FR)**

(72) Inventeur: **Fensch, Thierry**
**THOMSON-CSF SCPI 19, avenue de Messine**
**F-75008 Paris(FR)**
Inventeur: **Compagne, Eric**
**THOMSON-CSF SCPI 19, avenue de Messine**
**F-75008 Paris(FR)**

(74) Mandataire: **de Beaumont, Michel**
**1bis, rue Champollion**
**F-38000 Grenoble(FR)**

## Description

La présente invention concerne un circuit d'émission de signaux numériques dans le contexte d'un réseau téléphonique dit "réseau numérique à intégration de services".

Ce réseau comprend des lignes téléphoniques entre des centraux téléphoniques et des stations d'abonné, en vue de transmettre entre abonnés des conversations téléphoniques ainsi que d'autres informations circulant sous forme de signaux numériques.

La norme CCITT I430 prévoit que chaque abonné est connecté au réseau par l'intermédiaire d'un organe d'interface appelé "network termination" couplé d'une part aux deux fils d'une ligne téléphonique du réseau et d'autre part à un réseau local à quatre fils (un bus d'émission à deux fils et un bus de réception à deux fils) ; le réseau local relie l'organe d'interface à des terminaux locaux dont dispose l'abonné et qui peuvent être : un poste téléphonique, un poste de télécopie, une console pour liaisons alphanumériques en conversationnel, etc...

La norme mentionnée ci-dessus définit les fonctions et différentes caractéristiques que doit respecter notamment l'organe d'interface.

En particulier, cet organe comprend un circuit dit "circuit d'interface U" qui est connecté aux deux fils de la ligne téléphonique, par l'intermédiaire d'un transformateur, un circuit dit "circuit d'interface S" qui est connecté aux quatre fils du réseau local par l'intermédiaire d'un transformateur d'émission et d'un transformateur de réception, et enfin, entre ces deux circuits d'interface, un circuit de traitement de signal qui rend les signaux émis ou reçus sur deux fils compatibles avec les signaux émis et reçus sur quatre fils.

En ce qui concerne le circuit d'interface S, la norme définit en particulier les gabarits à respecter pour les signaux numériques émis vers les terminaux locaux dans différents cas d'émission, ainsi que les impédances du circuit vu du bus d'émission, cette impédance prenant en compte le transformateur d'émission placé entre le circuit d'interface S et le bus d'émission.

Plus spécifiquement, l'impédance doit être au moins de 2,5 K ohms entre 20 et 80 KHz pour un niveau de tension nul émis (ce niveau correspond à un niveau logique binaire 1 dans le type de codage numérique utilisé selon lequel l'état binaire 1 est défini par un niveau de tension nul et l'état binaire 0 est défini alternativement par un niveau de tension + 0,75 Volts puis par un niveau - 0,75 Volts).

Pour réaliser l'étage final d'attaque du transformateur d'émission, on peut envisager différentes solutions qui ont montré qu'elles avaient des inconvénients importants.

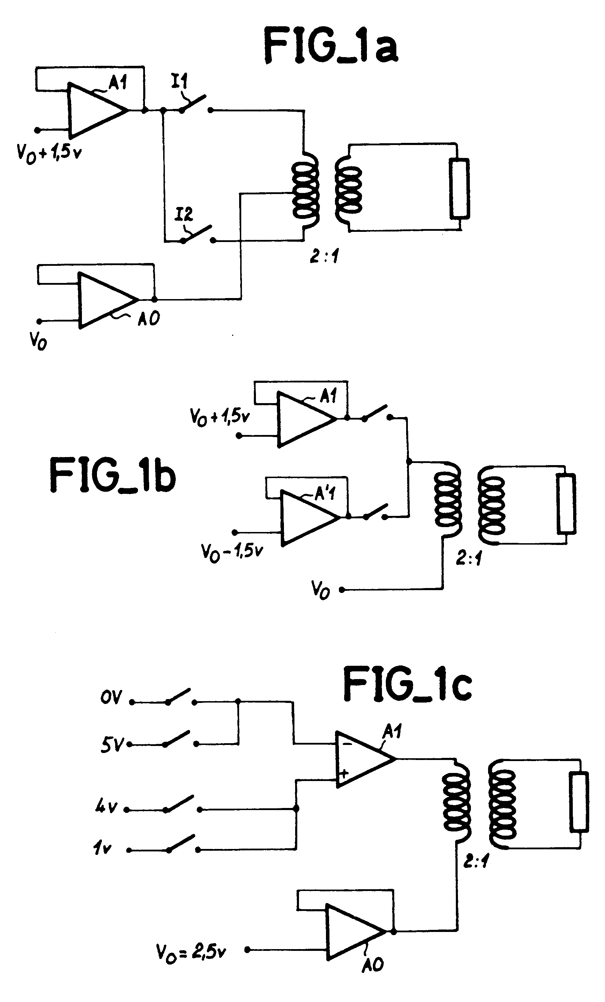

Ces solutions sont représentées aux figures 1a à 1c.

La solution de la figure 1a consiste à utiliser un transformateur dont le primaire possède un point milieu porté à un potentiel de référence $V_0$ et deux extrémités reliées chacune à un interrupteur (11, 12 respectivement) qui peut soit rester ouvert soit relier l'extrémité correspondante de l'enroulement primaire à un potentiel qui est $V1 = V_0 + 1,5$ Volt (le transformateur étant supposé affaiblir dans un rapport deux les niveaux de tension appliqués au primaire, pour obtenir des impulsions de + 0,75 Volts ou - 0,75 Volts au secondaire).

Le potentiel $V_0$ est appliqué par l'intermédaire d'un amplificateur tampon à gain unitaire $A_0$. Le potentiel $V_0 + 1,5$ Volts est appliqué par l'intermédiaire d'un amplificateur tampon à gain unitaire A1.

Cette solution est utilisable en technologie MOS mais elle nécessite un transformateur (à point milieu) ; elle présente des difficultés pour la commande des fronts des signaux à transmettre, et il s'avère finalement qu'elle ne permet pas de tenir tous les gabarits de forme d'impulsions de la norme CCITT 1430 ; en effet les fronts des signaux sont engendrés par la fermeture des interrupteurs 11 et 12 et sont trop raides, de sorte qu'ils engendrent des surtensions ne respectant pas les gabarits.

La figure 1b représente un schéma avec un transformateur sans point milieu, utilisable en technologie MOS mais présentant par ailleurs les mêmes inconvénients que la solution de la figure la ; de plus ce schéma risque d'engendrer une dissymétrie de fonctionnement si les sources de tension utilisées ne sont pas exactement égales à $V_0 + 1,5$ Volts et $V_0 -1,5$ Volts.

La figure 1c permet d'améliorer la qualité des fronts des signaux transmis ; on applique directement les sorties des amplificateurs aux extrémités des enroulements (sans passer par des interrupteurs) pour transmettre des niveaux de tension appropriés à l'enroulement primaire du transformateur.

L'amplificateur est contre-réactionné pour pouvoir tenir les gabarits d'impulsion dans les cas où l'impédance vue du point d'émission est de 50 ohms ou 400 ohms (la norme CCITT 1430 impose un gabarit pour 50 ohms, 400 ohms et 5,6 ohms). Mais la dynamique de sortie de l'amplificateur doit être telle que sa sortie puisse passer de 1 Volt à 4 Volts (1,5 volts de part et d'autre d'un point milieu à 2,5 volts). Ces valeurs sont trop proches de la tension d'alimentation (0 - 5 volts) de l'amplificateur et, comme on doit fournir un courant important d'environ 7,5 mA sur 200 ohms, cela nécessiterait de très gros transistors dans l'étage de sortie de chacun des deux amplificateurs utilisés. Comme dans le schéma de la figure 1b, un problème de dissymétrie existe si les sources de tension de référence ont des niveaux mal ajustés.

Le document GB-A-1 598 679 propose un circuit d'émission à pont de quatre transistors MOS.

D'autres solutions ont été proposées, mais elles sont réalisées en technologie bipolaire et ne sont pas transposables en technologie MOS car elles utilisent des propriétés spécifiques des éléments bipolaire, non transposables pour les éléments MOS, comme par exemple les limitations de courant faites par des diodes dérivant une partie du courant de la base des transistors bipolaires.

Or on souhaite dans certains cas avoir une solution en technologie MOS pour la réalisation de ce circuit d'emission, ne serait-ce que parce que le reste de l'organe d'interface comprend beaucoup de logique qu'il est préférable de réaliser en technologie à faible consommation (MOS ou mieux CMOS).

C'est pourquoi la présente invention propose un nouveau circuit d'émission, réalisé en technologie CMOS, pour transmettre des signaux numériques vers une ligne bipolaire à travers un transformateur.

Le circuit d'émission possède une première borne et une seconde borne de sortie reliées aux extrémités d'un enroulement primaire du transformateur, le secondaire étant relié à la ligne.

Le circuit comprend un premier transistor à effet de champ, à canal N, de champ, en série avec un deuxième transistor à effet de champ, à canal P, leur point de jonction étant relié à la première borne de sortie, un troisième transistor à effet de champ, à canal P, en série avec un quatrième transistor à effet de champ, à canal N, leur point de jonction étant relié à la deuxième borne de sortie, quatre amplificateurs différentiels commandant chacun la grille de l'un des transistors, les amplificateurs ayant chacun une entrée inverseuse et une entrée non-inverseuse, les entrées non-inverseuses des deux premiers amplificateurs étant reliées à la première borne de sortie et les entrées non-inverseuses des deux autres étant reliées à la deuxième borne de sortie, le circuit comprenant encore un circuit logique pour appliquer aux entrées inverseuses des amplificateurs des signaux impulsionnels selon les principes suivants:

- un potentiel de référence bas Vss est appliqué aux deuxième et troisième amplificateurs et un potentiel de référence haut Vdd est appliqué aux premier et quatrième amplificateurs lorsqu'aucun signal impulsionnel ne doit être transmis ;
- un premier potentiel intermédiaire est appliqué au premier amplificateur, en même temps qu'un deuxième potentiel intermédiaire est appliqué au troisième amplificateur, le deuxième amplificateur recevant toujours le potentiel bas Vss et le quatrième recevant toujours le potentiel haut Vdd, ceci pour transmettre un signal impulsionnel d'une première polarité ;
- le premier potentiel intermédiaire est appliqué au quatrième amplificateur en même temps que le deuxième potentiel intermédiaire est appliqué au deuxième amplificateur, le premier amplificateur recevant le potentiel haut Vdd et le troisième amplificateur recevant le potentiel bas Vss, ceci pour transmettre un signal impulsionnel d'une deuxième polarité opposée à la première.

D'autres caractéristiques et avantages de l'invention apparaitront à la lecture de la description détaillée qui suit et qui est faite en référence aux dessins annexés dans lesquels :
- les figures 1a à 1c représentent des exemples de schémas de circuits d'émission selon l'art antérieur
- la figure 2 représente de manière schématique le circuit d'émission selon la présente invention.
- la figure 3 représente un schéma détaillé d'un exemple de réalisation
- la figure 4 représente un circuit de commutation des tensions appliquées aux entrées du circuit de la figure 3.

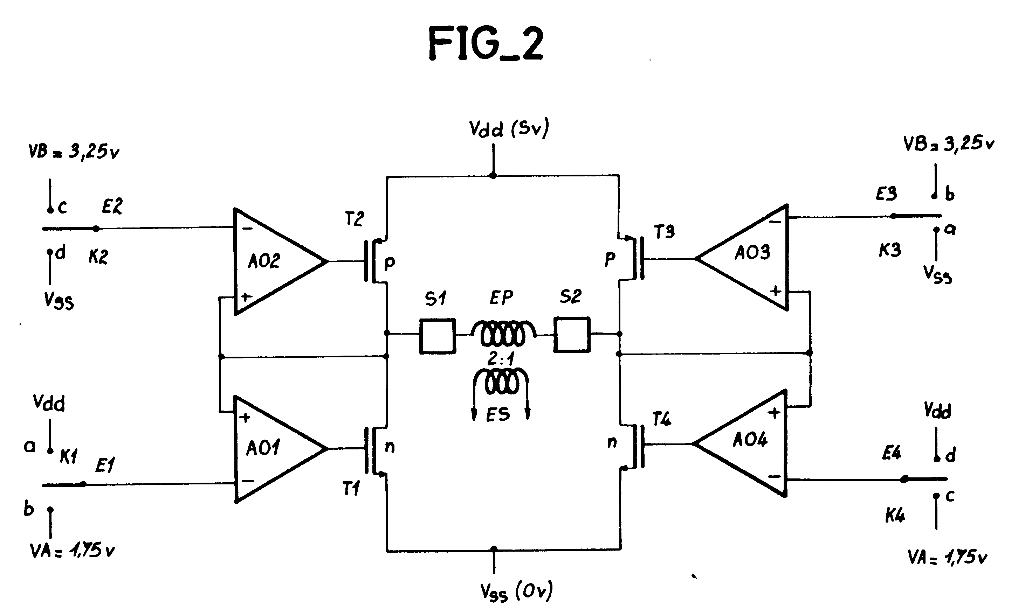

Sur la figure 2, on voit que le circuit d'émission comporte essentiellement quatre amplificateurs différentiels AO1, AO2, AO3, et AO4, ayant chacun une entrée inverseuse repérée par le signe "-" et une entrée non-inverseuse repérée par le signe "+".

Chaque amplificateur attaque la grille de commande d'un transistor de sortie respectif, respectivement T1 à T4, qui sont des transistors à effet de champ et qui sont agencés de la manière suivante:
- le transistor T1, commandé par l'amplificateur AO1, est un transistor à canal N, ayant sa source reliée à une ligne à un potentiel de référence bas Vss, et ayant son drain relié au drain du transistor T2,
- le transistor T2, commandé par l'amplificateur AO2, est un transistor à canal P, ayant sa source reliée à une ligne portée à un potentiel de référence haut Vdd,
- le transistor T3, commandé par l'amplificateur AO3, est un transistor à canal P, ayant sa source reliée à la ligne au potentiel haut Vdd et ayant son drain relié au drain du transistor T4,
- le transistor T4, commandé par l'amplificateur AO4, est un transistor à canal N ayant sa source reliée à la ligne au potentiel bas Vss.

Les drains des transistors T1 et T2 sont reliés ensemble aux entrées non-inverseuses réunies des amplificateurs AO1 et AO2. Ils sont reliés par ailleurs à une première borne de sortie S1 du circuit d'émission.

D'une manière tout à fait symétrique, les drains des transistors T3 et T4 sont reliés aux entrées non-inverseuses réunies des amplificateurs AO3 et AO4, et ils sont par ailleurs reliés à une deuxième borne de sortie S2 du circuit d'émission.

Les bornes de sortie S1 et S2 sont reliées aux deux extrémités de l'enroulement primaire EP d'un transformateur; l'enroulement secondaire ES du transformateur constitue l'organe de sortie proprement dit du circuit d'émission; le rapport de transformation des tensions entre le primaire et le secondaire du transformateur est de préférence de deux à un.

Les entrées du circuit qui vient d'être décrit sont quatre entrées E1, E2, E3, E4, sur lesquelles on applique des potentiels de différentes valeurs avec des phases bien déterminées que l'on explicitera plus loin.

L'entrée E1, reliée à l'entrée inverseuse de l'amplificateur AO1, peut recevoir, à travers un commutateur K1, soit le potentiel haut Vdd, soit un premier potentiel intermédiaire VA. La valeur de VA est de préférence de 1,75 volts pour un potentiel Vdd = 5 volts et Vss = 0 volt

L'entrée E2, reliée à l'entrée inverseuse de l'amplificateur AO2, peut recevoir, à travers un commutateur K2, soit le potentiel bas Vss, soit un deuxième potentiel intermédiaire VB. La valeur de VB est de préférence de 3,25 volts pour les valeurs indiquées ci-dessus pour Vdd et Vss.

L'entrée E3, reliée à l'entrée inverseuse de l'amplificateur AO3, peut recevoir, à travers un commutateur K3, soit le potentiel bas Vss, soit le deuxième potentiel intermédiaire VB.

L'entrée E4, reliée à l'entrée inverseuse de l'amplificateur AO4, peut recevoir, à travers un commutateur K4, soit le potentiel Vdd, soit le premier potentiel intermédiaire VA.

Le fonctionnement du circuit est le suivant:

- un potentiel de référence bas Vss est appliqué aux entrées E2 et E3, et un potentiel haut Vdd est appliqué aux entrées E1 et E4, lorsqu'aucun signal impulsionnel ne doit être transmis par le circuit d'émission;
- le premier potentiel intermédiaire VA est appliqué à l'entrée E1 et le deuxième potentiel intermédiaire VB est appliqué à l'entrée E3, l'entrée E2 restant à Vss et l'entrée E4 à Vdd, lorsqu'un signal impulsionnel d'une première polarité doit être transmis;
- le deuxième potentiel intermédiaire VB est appliqué à l'entrée E2 et le premier potentiel intermédiaire VA est appliqué à l'entrée E4, l'entrée E1 restant à Vdd et l'entrée E3 à Vss, lorsqu'un signal impulsionnel ayant une deuxième polarité, opposée à la première, doit être transmis.

Sur la figure 2, on a indiqué par des lettres a, b, c, d, les phases de commutation des commutateurs qui transmettent les tensions appropriées: les commutateurs K1 et K3 travaillent en phase l'un avec l'autre, la phase a correspondant à l'absence de transmission de signal ou à une transmission d'un signal de la deuxième polarité, et la phase b correspondant à la transmission d'une signal de la première polarité; de même, les commutateurs K2 et K4 travaillent en phase l'un avec l'autre, la phase c correspondant à la transmission d'un signal de deuxième polarité, et la phase d correspondant à l'absence de transmission de signal ou à la transmission d'un signal de première polarité. Les phases b et c sont en tous cas disjointes.

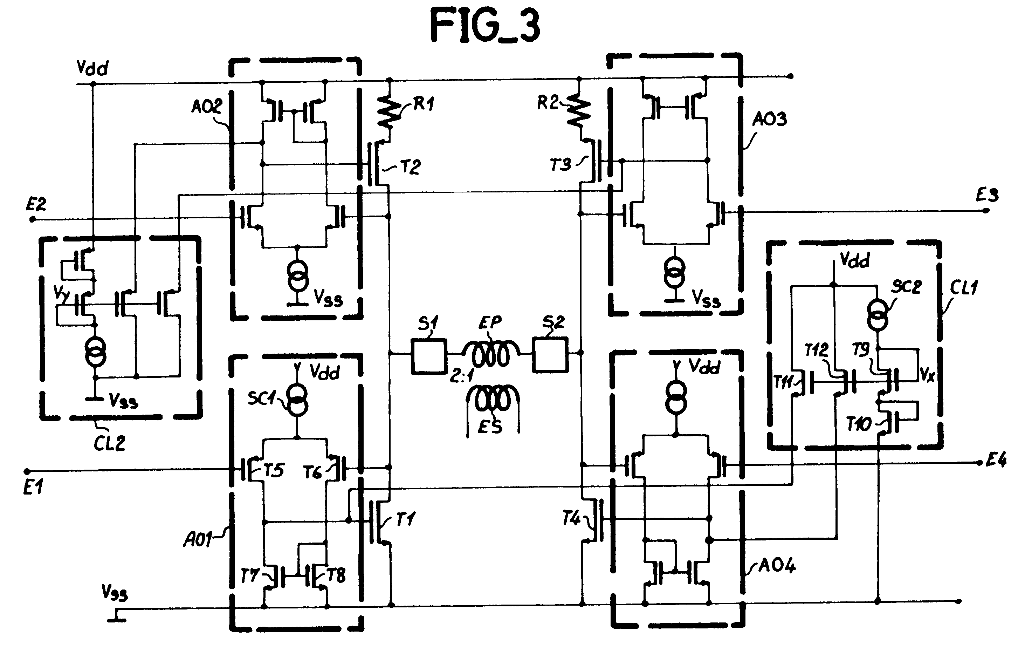

La figure 3 représente un exemple de réalisation détaillée du circuit de la figure 2, à l'exception des commutateurs d'entrée. Les mêmes éléments portent les mêmes références, et en particulier les entrées E1 à E4, les sorties S1 et S2, les amplificateurs AO1, à AO4, et les transistors à effet de champ complémentaires T1 et T4 (canal N) et T2 et T3 (canal P).

Les amplificateurs différentiels sont de type classique. Par exemple, l'amplificateur AO1 comporte deux transistors d'entrée T5 et T6 dont les grilles constituent les deux entrées de l'amplificateur; on voit clairement la contre-réaction positive (liaison de la grille de T6 avec la borne S1) par laquelle la tension du point E1 est recopiée sur la sortie S1. Avec ce type d'amplificateur, on peut limiter la vitesse d'attaque à une valeur raisonnable engendrant des fronts de montée pas trop abrupts pour le signal de sortie du circuit. On choisit en conséquence le courant de polarisation et le courant de charge de l'amplificateur.

L'amplificateur AO1 comporte encore deux autres transistors T7 et T8 montés en miroirs de courant, le transistor T7 étant en série avec T5 et le transistor T8, monté en diode, étant en série avec le transistor T6; une source de courant constant SC1 alimente l'ensemble en parallèle de la branche T5, T7 et de la branche T6, T8.

On notera qu'on a prévu dans le schéma de la figure 3 deux résistances R1 et R2, l'une en série avec la source du transistor T2 et l'autre en série avec la source du transistor T3; ces résistances, rajoutées par rapport au schéma de la figure 2, ne modifient pas le fonctionnement du circuit; elles sont là dans le cas où on veut pouvoir détecter le passage d'un courant trop élevé dans les transistors de sortie; dans ce cas, la tension aux bornes de ces résistances est transmise à un circuit comparateur à seuil (non représenté) qui agit par exemple pour couper les signaux d'entrée si un courant trop élevé est détecté.

Chaque groupe de transistors de sortie en série, T1, T2 d'une part et T3, T4 d'autre part, est relié par ailleurs à un circuit de polarisation respectif qui agit pour maintenir ces transistors en limite de conduction (au lieu de les bloquer fortement).

En effet, le problème qui se pose est le suivant: on veut que le circuit d'émission ait un temps de réaction rapide, entre le moment d'application d'un signal d'entrée et l'apparition d'un signal de sortie (temps inférieur à 300 nanosecondes); mais on veut aussi que le temps de montée de ce signal ne soit pas trop bref; ces exigences sont contradictoires et on résoud ici cette contradiction en maintenant une différence de potentiel minimale entre grille et source des transistors de sortie T1 à T4 lorsqu'ils sont dans un état bloqué.

Ceci est effectué par un circuit CL1 pour les transistors à canal N (T1 et T4) et par un circuit CL2 pour les transistors à canal P (T2 et T3).

Le circuit CL1 comprend une source de courant SC2 alimentant un ensemble de deux transistors T9, T10 en série, ayant chacun sa grille reliée à son drain, la source du deuxième transistor T10 étant au potentiel Vss.

La grille du transistor T9 est reliée à la grille d'un transistor T11 dont le drain est au potentiel Vdd et dont la source est reliée à la grille du transistor T1. La grille du transistor T9 est aussi reliée à la grille d'un transistor T12 dont le drain est au potentiel Vdd et dont la source est reliée à la grille du transistor T4.

Il résulte de cette disposition que la grille des transistors T1 et T4 ne peut pas descendre à un potentiel plus bas que Vx-Vt si Vx est la tension de grille commune des transistors T9, T11, T12, et Vt est la tension de seuil des transistors T11 et T12.

Le circuit CL1 est constitué de transistors à canal N; la description et le fonctionnement du circuit CL2 sont analogues à ceux du circuit CL1 mais il faut remplacer les transistors à canal N par des transistors à canal P et permuter Vdd et Vss. Grâce au circuit CL2, la tension de grille des transistors T2 et T3 ne peut pas monter au dessus d'une valuer Vdd-Vy+Vt′ si Vy est la tension de grille commune des transistors du circuit CL2 et Vt′ est la tension de seuil de transistors à canal P du circuit CL2.

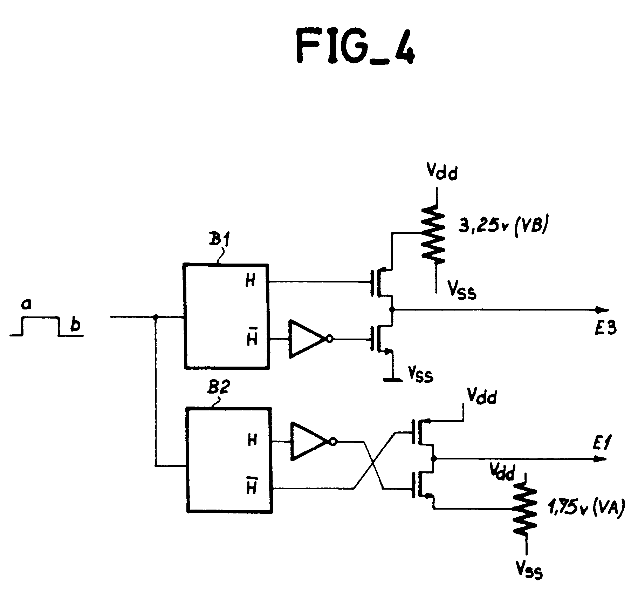

Pour terminer, on a représenté à la figure 4, un circuit de commutation (symbolisé sur la figure 2 par les commutateurs K1 et K3) capable de transmettre aux entrées E1 et E3 les tensions appropriées (Vdd, Vss, VA, VB). Ce circuit a pour entrée un signal logique représentant la phase a (niveau logique haut) et la phase b (niveau bas); il a pour sorties les bornes E1 et E3 des figures 2 et 3. Un circuit identique est prévu pour commander les bornes E2 et E4, mais il est commandé par un signal logique représentant les phases c et d.

Le circuit de la figure 4 comporte deux bascules B1 et B2 qui ont de préférence la particularité de fournir sur leurs sorties complémentaires des transitions légèrement décalées dans le temps l'une par rapport à l'autre, le front de montée des sorties désignées par H étant en avance sur le front de descente des sorties complémentaires.

Ces deux bascules reçoivent comme signal d'entrée le signal logique définissant les phases complémentaires a et b (ou c et d pour le circuit de commande des bornes E2 et E4).

La sortie H de la bascule B1 commande directement la grille d'un transistor à canal P dont la source est au potentiel VB; ce potentiel est obtenu par un pont diviseur. La sortie complémentaire, de la bascule B1 commande, à travers un inverseur, la grille d'un transistor à canal N dont le drain est relié au drain du transistor à canal P et dont la source est reliée au potentiel Vss.

Le point de jonction de ces deux transistors est relié à l'entrée E3 (E2 pour le circuit identique commandé par les phases c,d).

La sortie H de la bascule B2 commande, par l'intermédaire d'un inverseur, un transistor à canal N dont la source est reliée au potentiel VA (obtenu par un pont diviseur). La sortie complémentaire de la bascule B2 commande directement un transistor à canal P dont le drain est relié au drain du transistor à canal N et dont la source est reliée au potentiel Vdd.

Le point de jonction des deux transistors est relié à l'entrée E1 (ou E4 pour le circuit commandé par les phases C et d).

**Revendications**

1. Circuit d'émission de signaux numérique, destiné à émettre des signaux numériques vers une ligne bifilaire à travers un transformateur comprenant un enroulement primaire dont les extrémités sont reliées à une première et une seconde bornes de sortie (S1, S2) du circuit d'émission, un enroulement secondaire relié à la ligne, un premier transistor à effet de champ (T1), à canal N, en série avec un deuxième transistor à effet de champ (T2), à canal P, leur point de jonction étant relié à la première borne de sortie (S1), et un troisième transistor à effet de champ (T3), à canal P, en série avec un quatrième transistor à effet de champ (T4), à canal N, leur point de jonction étant relié à le deuxième borne de sortie (S2), caractérisé en ce qu'il comprend quatre amplificateurs différentiels (AO1, AO2, AO3, AO4) commandant chacun la grilie de l'un des transistors T1, T2, T3, T4), les amplificateurs ayant chacun une entrée inverseuse et une entrée non-inverseuse, les entrées non-inverseuses des deux premiers amplificateurs étant reliées à la première borne de sortie et les entrées non-inverseuses des deux autres étant reliées à la deuxième borne de sortie, le circuit comprenant encore un circuit logique pour appliquer aux entrées inverseuses des amplificateurs des signaux impulsionnels selon les principes suivants:

- un potentiel de référence bas Vss est appliqué aux deuxième et troisième amplificateurs (AO2 et AO3) et un potentiel de référence haut Vdd est appliqué aux premier et quatrième amplificateurs (AO1 et AO4) lorsqu'aucun signal impulsionnel ne doit être transmis;
- un premier potentiel intermédiaire (VA) est appliqué au premier amplificateur, en même temps qu'un deuxième potentiel intermédiaire (VB) est appliqué au troisième amplificateur, le deuxième amplificateur recevant toujours le potentiel bas Vss et le quatrième recevant toujours le potentiel haut Vdd, ceci pour transmettre un signal impulsionnel d'une première polarité;
- le premier potentiel intermédiaire (VA) est appliqué au quatrième amplificateur en même temps que le deuxième potentiel intermédiaire (VB) est appliqué au deuxième amplificateur, le premier amplificateur recevant le potentiel haut Vdd et le troisième amplificateur recevant le potentiel bas Vss, ceci pour transmettre un signal impulsionnel d'une deuxième polarité opposée à la première.

2. Circuit d'émission selon le revendication 1, caractérisé en ce qu'il est prévu en outre un circuit pour empêcher la tension grille-source des transistors de descendre en valeur absolue au dessous d'une valuer prédéterminée proche de la tension de seuil de ces transistors.

**Claims**

1. A circuit for the transmission of digital signals, designed to transmit signals to a two-wire line, through a transformer comprising a primary winding, the ends of which are connected to a first and a second output terminal (S1, S2) of said transmitting circuit, a secondary winding connected to the line, a first N-channel field-effect transistor (T1) which is series-connected with a second P-channel field-effect transistor (T2) with their junction point connected to the first output terminal (S1), and a third P-channel field-effect transistor (T3) which is series-connected with a fourth N-channel field-effect transistor (T4) with their junction point connected to the second output terminal (S2), characterized in this that it comprises four differential amplifiers (AO1, AO2, AO3, AO4), each controlling the gate of one of the transistors (T1, T2, T3, T4), each amplifier having an inverting input and a non-inverting input, the non-inverting inputs of the first two amplifiers being connected to the first output terminal and the non-inverting inputs of the other two amplifiers being connected to the second output terminal, said circuit further comprising a logic circuit to apply pulse signals to the inverting inputs of the amplifiers according to the following rules:

- a low reference potential (Vss) is applied to the second and third amplifiers (AO2 and AO3) and a high reference potential (Vdd) is applied to the first and fourth amplifiers (AO1 and AO4) when no pulse signal should be transmitted;
- a first intermediate potential (VA) is applied to the first amplifier at the same time as a second intermediate potential (VB) is applied to the third amplifier, the second amplifier always receiving the low potential (Vss) and the fourth always receiving the high potential (Vdd) so as to transmit a pulse signal with a first polarity;
- the first intermediate potential (VA) is applied to the fourth amplifier at the same time as the second intermediate potential (VB) is applied to the second amplifier, the first amplifier receiving the high potential (Vdd) and the third amplifier receiving the low potential (Vss) in order to transmit a pulse signal with a second polarity opposite to the first polarity.

2. A transmission circuit according to claim 1, characterized in this that it further comprises a circuit to prevent the gate-source voltage of the transistors from descending, in terms of absolute value, below a predetermined value close to the threshold voltage of said transistors.

**Patentansprüche**

1. Sendeschaltung zur Übertragung digitaler Signale, die zur Übertragung digitaler Signale auf eine zweiadrige Leitung unter Durchlaufung eines Wandlers ausgelegt ist, mit einer Primärwicklung, deren Enden mit einem ersten und einem zweiten Ausgangsanschluß (S1, S2) der Sendeschaltung verbunden sind, einer mit der Leitung verbundenen Sekundärwicklung, einem ersten, N-Kanal-Feldeffekttransistor (T1), der mit einem zweiten, P-Kanal-Feldeffekttransistor (T2) in Reihe geschaltet ist, wobei der Verbindungspunkt der Transistoren mit dem ersten Ausgangsanschluß (S1) verbunden ist, und mit einem dritten , P-Kanal-Feldeffekttransistor (T3), der mit einem vierten, N-Kanal-Feldeffekttransistor (T4) in Reihe geschaltet ist, wobei der Verbindungspunkt dieser Transistoren mit dem zweiten Ausgangsanschluß (S2) verbunden ist,

dadurch gekennzeichnet, daß vier Differenzverstärker (AO1, AO2, AO3, AO4) vorhanden sind, deren jeder das Gate je eines Transistors (T1, T2, T3, T4) steuert, wobei jeder Verstärker einen invertierenden Eingang und einen nicht-invertierenden Eingang aufweist und die nicht-invertierenden Eingänge der beiden ersten Verstärker mit dem ersten Ausgangsanschluß verbunden sind und die nicht-invertierenden Eingänge der beiden anderen Verstärker mit dem zweiten Ausgangsanschluß verbunden sind, wobei die Schaltung weiterhin eine logische Schaltung beinhaltet zum Anlegen von Impulssignalen an die invertierenden Eingänge der Verstärker nach folgenden Prinzipien:

- ein niedriges Bezugspotential (Vss) wird an den zweiten und den dritten Verstärker (AO2 und AO3) angelegt, und ein hohes Bezugspotential (Vdd) wird an den ersten und den vierten Verstärker (AO1 und AO4) angelegt, wenn kein Impulssignal übertragen werden soll;
- gleichzeitig mit der Anlegung eines ersten Zwischenpotentials (VA) an den ersten Verstärker wird ein zweites Zwischenpotential (VB) an den dritten Verstärker angelegt, wobei dem zweiten Verstärker stets das niedrige Potential zugeführt wird und dem vierten Verstärker stets das hohe Potential (Vdd) zugeführt wird, um dadurch ein Impulssignal mit einer ersten Polarität zu übertragen;
- gleichzeitig mit der Anlegung des ersten Zwischenpotentials (VA) an den vierten Verstärker wird das zweite Zwischenpotential (VB) an den zweiten Verstärker angelegt, wobei dem ersten Verstärker das hohe Potential (Vdd) zugeführt wird und dem dritten Verstärker das niedrige Potential (Vss) zugeführt wird, um dadurch ein Impulssignal mit einer der ersten Polarität entgegengesetzten, zweiten Polarität zu übertragen.

2. Sendeschaltung nach Anspruch 1, dadurch gekennzeichnet, daß weiterhin eine Schaltung vorgesehen ist, die ein Absinken der Gate-Source-Spannung der Transistoren hinsichtlich ihres Absolutwerts unter einen vorbestimmten Wert nahe bei der Schwellenwertspannung der Transistoren verhindert.

# FIG_1a

# FIG_1b

# FIG_1c

# FIG_2

VB = 3,25v

c    E2

d    K2

Vss

VB = 3,25v

E3    b

a

K3

Vss

Vdd (Sv)

T2    P    P    T3

AO2    AO3

S1    EP    S2

2:1

ES

Vdd    Vdd

a    K1    E1    T4

b    AO1    n    n    AO4    E4    d

T1    K4    c

VA = 1,75v    Vss (0v)    VA = 1,75v

EP 0 272 171 B1

# FIG_3

EP 0 272 171 B1

# FIG_4